# NEUE EUROPÄISCHE PATENTSCHRIFT

(11) **EP 1 022 787 B2**
(45) Veröffentlichungstag und Bekanntmachung des Hinweises auf die Entscheidung über den Einspruch: **11.07.2012**
(45) Hinweis auf die Patenterteilung: 07.05.2003
(21) Anmeldenummer: 99124677.8
(22) Anmeldetag: 31.05.1989
(51) Int. Cl.: H01L 31/0232, H01L 31/0203, H01L 33/00, G09F 9/33

(54) **Verfahren zum Herstellen eines oberflächenmontierbaren Opto-Bauelements und oberflächenmontierbares Opto-Bauelement**
Method of producing a surface-mountable optical element and surface-mountable optical element
Procédé de production d'un élément optique fixable sur une surface et élément optique fixable sur une surface

(43) Veröffentlichungstag der Anmeldung: 26.07.2000
(62) Teilanmeldung aus: 89109835.2
(73) Patentinhaber: OSRAM Opto Semiconductors GmbH, 93055 Regensburg (DE)
(72) Erfinder: Waitl, Günther, 93049 Regensburg (DE); Schellhorn, Franz, 93049 Regensburg (DE)
(74) Vertreter: Epping - Hermann - Fischer

(56) Entgegenhaltungen:
- WO-A-83/00408
- JP-A- 1 108 753
- JP-A- 61 042 939
- JP-A- 63 299 368
- US-A- 3 914 786
- PATENT ABSTRACTS OF JAPAN vol. 004, no. 157 (E-032), 4. November 1980 (1980-11-04) & JP 55 105388 A (TOSHIBA CORP), 12. August 1980 (1980-08-12)
- PATENT ABSTRACTS OF JAPAN vol. 009, no. 136 (E-320), 12. Juni 1985 (1985-06-12) & JP 60 020587 A (SANYO DENKI KK;OTHERS: 02), 1. Februar 1985 (1985-02-01)
- PATENT ABSTRACTS OF JAPAN vol. 006, no. 170 (E-128), 3. September 1982 (1982-09-03) & JP 57 085273 A (TOSHIBA CORP), 27. Mai 1982 (1982-05-27)
- PATENT ABSTRACTS OF JAPAN vol. 012, no. 228 (E-627), 28. Juni 1988 (1988-06-28) & JP 63 019879 A (CANON INC), 27. Januar 1988 (1988-01-27)

## Beschreibung

Die Erfindung betrifft ein Verfahren zum Herstellen eines oberflächenmontierbaren Opto-Bauelements und ein oberflächenmontierbares Opto-Bauelement.

SMD (Surface Mounted Devices) steht für eine neue Aufbautechnik von Flachbaugruppen. Es umfaßt sowohl eine neue Art der Verarbeitung der Bauelemente, nämlich die Oberflächenmontage, als auch eine neue Generation von Bauelementen, die zu der neuen Technik passen müssen.

Die Oberflächenmontage wird die herkömmliche Technik der Einsteckmontage mehr und mehr ablösen. Oberflächenmontage heißt, daß unbedrahtete Bauelemente anstelle von bedrahteten auf eine Leiterplatte oder auf ein sonstiges Substrat gebracht werden. Mit SMD können weitere Vorteile genutzt werden: Die Flachbaugruppen werden bis zu 70 % kleiner, die Fertigung wird rationeller, die Zuverlässigkeit wird größer.

Die oberflächenmontierbaren Bauelemente sind dann wirtschaftlich zu verwenden, wenn sie in Bestückautomaten verarbeitet werden. Die Vorteile der Oberflächenmontage sind um so größer, je besser Bauelemente, Leiterplatten-Layout, automatische Bestückung, Löttechnik, Prüfen aufeinander abgestimmt sind.

Oberflächenmontierbare Opto-Bauelemente sind aus EP-A-0 083 627 bekannt. Dabei ist in einer Vertiefung eines Substrats aus Keramikmaterial ein optoelektronischer Halbleiterkörper angeordnet. Über dem Halbleiterkörper ist eine aus Epoxidharz bestehende lichtdurchlässige Schicht mit domartiger Wölbung angeordnet. Dieses bekannte Bauelement ist im wesentlichen für Display-Anordnungen gedacht. Bei einer solchen Displayanordnung ist über dem Bauelement ein Reflektor angeordnet, der auf einer Leiterplatte mittels Justierhilfen positioniert ist.

Aus der Druckschrift JP-A-55105388 ist ein Verfahren zum Herstellen eines LED-Bauelements bekannt, bei dem ein LED-Chip auf ein Leadframe montiert wird, das nachfolgend mit einem haubenförmigen Gehäuseteil umgossen wird. Das Innere des Gehäuses wird mit einem klaren Acrylharz gefüllt. Die elektrischen Anschlüsse für die LED ragen an der Rückseite des Gehäuses heraus. Dieses LED-Bauelement ist ausschließlich für die sogenannte Durchsteck-Montage geeignet, bei der die elektrischen Anschlüsse durch eine Leiterplatte durchgesteckt und auf deren Rückseite verlötet werden. Eine Oberflächenmontage ist mit diesem Bauelement nicht möglich. Im Übrigen ist für die Herstellung des haubenförmigen Gehäuseteils eine kompliziert ausgestaltete Gußform erforderlich, die den LED-Träger des Leadframes hinterschneidet. Ein ähnliches Bauelement ist aus der japanischen Offenlegungsschrift JP-A-57085273 bekannt.

Die Druckschrift JP-A-01108753 beschreibt ein Verfahren zum Herstellen eines photoelektrischen Halbleiterbauelements, bei dem eine Rückseite eines Leadframes zunächst mit einem lichtabschirmenden Gießformteil versehen wird, das ein sich zur Vorderseite des Bauelements hin erstreckendes Wandteil aufweist. Das Wandteil umgibt seitlich einen Chipanschlußteil des Leadframes. Nach dem Montieren und Bonden des Chips auf dem Chipanschlußteil wird ein lichtdurchlässiges Gießformteil ausgebildet, das den Chip einschließlich Bonddrähte umhüllt und die Oberseite des Wandteils bedeckt. Externe elektrische Anschlußstreifen des Leadframes ragen seitlich aus dem Gehäuse heraus, das aus dem lichtabschirmenden Gießformteil und dem lichtdurchlässigen Gießformteil gebildet ist, und werden außerhalb des Gehäuses jeweils mittels einer s-artigen Biegung zu einer Montageebene des Bauteils hin zu vom Gehäuse weg ragenden oberflächenmontierbaren Lötanschlüssen geformt. Mit dieser Formgebung der elektrischen Anschlußstreifen läßt sich der Biegestress im Gehäuse gering halten. Die vom Gehäuse weg ragenden Lötanschlüsse rufen aber einen vergleichsweise hohen Platzbedarf auf Leiterplatten hervor.

In der Druckschrift JP-A-61042939 ist allgemein ein chipartiges oberflächenmontierbares Halbleiterbauelement beschrieben, bei dem elektrische Anschlußstreifen eines Leadframes seitlich aus einem Harzverguß für einen Halbleiterchip herausgeführt sind und im Verlauf zu einer Rückseite des Harzvergusses hin jeweils mehrere Biegungen aufweisen. Die Biegungen bewirken, dass die Anschlußstreifen in vertikaler und in lateraler Richtung federn. Sie dienen als Puffer zur Absorption von mechanischem Stress während der Montage des Halbleiterbauelements auf einem Anschlußsubstrat mittels eines Montageautomaten. Eine ausreichende Federung wird dadurch erzielt, dass die Steifigkeit der Anschlußsstreifen im Bereich der Biegungen hinreichend reduziert ist. Dazu weisen die Anschlußstreifen außerhalb des Harzvergusses jeweils im Bereich zwischen dem Harzverguß und einem zugehörigen Kontaktteil eine reduzierte Breite auf. Die Kontaktteile der Anschlußstreifen sind unter den Harzverguß gebogen. Der Harzverguß besitzt Ausnehmungen, um den elektrischen Anschlußstreifen ausreichend Federweg zur Verfügung zu stellen. Derartige chipartige oberflächenmontierbare Halbleiterbauelemente können Toleranzen von Montageautomaten kompensieren und haben zudem einen geringen Platzbedarf auf Leiterplatten. Sie werden aber beim Herstellen der federnden Biegungen mechanisch sehr stark beansprucht, was leicht zu Bauteilschäden, insbesondere an der Grenze zwischen Harzverguß und Leadframe führen kann. Darüber hinaus ist zur Formung der federnden Bereiche ein komplexer Biegeprozeß erforderlich, der den technischen Aufwand und damit verbunden den Kostenaufwand für die Bauteilproduktion erhöht.

Die Druckschrift JP Design Patent No. 744802 beschreibt eine LED, bei der die Anschlüsse in schmalen Bereichen aus einem Grundkörper herausgeführt und ebenfalls in den schmalen Bereichen zur Rückseite gebogen sind.

Der vorliegenden Erfindung liegt die Aufgabe zugrunde, ein verbessertes Verfahren zum Herstellen eines oberflächenmontierbaren Opto-Bauelements und ein verbessertes oberflächenmontierbares Opto-Bauelement anzugeben. Das Verfahren bzw. das Opto-Bauelement soll kostengünstig sein und ermöglichen, Bauelemente herzustellen, die auf den handelsüblichen Bestückautomaten der SMD-Technik verarbeitbar sind.

Diese Aufgabe wird erfindungsgemäß durch ein Verfahren mit den Merkmalen des Anspruches 1 und durch ein Opto-Bauelement mit den Merkmalen des Anspruches 7 gelöst.

Ausgestaltungen und Vorteile der Erfindung sind in den Unteransprüchen 2 bis 6 bzw. 8 bis 12, der Beschreibung und den Zeichnungen angegeben.

Bei der vorliegenden Erfindung ist es möglich, daß eine optische Einrichtung zur Formung des abzustrahlenden oder zu empfangenden Lichts so auf dem Grundkörper aufliegt, daß zwischen der optischen Einrichtung und dem Grundkörper seitlich praktisch kein Licht verloren geht.

Bei der vorliegenden Erfindung werden Sender- oder Empfänger in Vertiefungen des Grundkörpers angeordnet. Dadurch wird ein Übersprechen zwischen verschiedenen Sendern auf einer Leiterplatte oder auf einem Substrat, auf dem mehrere Grundkörper angeordnet sind, vermieden. Eine solche Vertiefung kann in einfacher Weise als Reflektor ausgebildet werden.

Wenn ein Empfänger in einer Vertiefung angeordnet wird, so ist das Nutz-Stör-Signal-Verhältnis deutlich verbessert wegen der verringerten Seitenlicht-Empfindlichkeit.

Da bei der vorliegenden Erfindung der Grundkörper keine domartige Wölbung an seiner Oberfläche aufweist, ist er mit Hilfe einer herkömmlichen SMD-Bestückungsvorrichtung genauer positionierbar.

Vorteilhafterweise besitzt der Grundkörper eine im wesentlichen plane Oberfläche, was für die Bestücktechnik günstig ist.

Die Erfindung ermöglicht die Herstellung von oberflächenmontierbaren Opto-Bauelementen mit variabler Optik bei geringem Herstellungsaufwand. Für jede Variation in der Optik mußte beim Stand der Technik ein extra angepaßtes Gehäuse hergestellt werden. Dies erfordert hohe Investitionen im Bereich der Endmontage, insbesondere bei der Bauteilumhüllung. Zusätzlich engen die Montagemöglichkeiten der SMD-Bestückautomaten die Gestaltung der Optik ein.

Die Erfindung ermöglicht die Herstellung oberflächenmontierbarer Bauformen (Grundbauelemente), die kostengünstig herstellbar, auf den handelsüblichen Bestückautomaten verarbeitbar sind und bei denen es möglich ist, daß erst nach dem Montage- und Löt-Prozeß diese Grundbauelemente mit einer dem jeweiligen Anwendungsfall angepaßten Optik gekoppelt werden.

Durch die Trennung von Grundkörper und Optik (optischer Einrichtung) wird die Anzahl der Bauformen stark reduziert. Die hohen Anforderungen, die an ein SMD-Bauelement bezüglich der Montierbarkeit und der Lötbarkeit gestellt werden, sind mit einem Bauelement nach der Erfindung sicherer zu realisieren. Die Gestaltung der Optik kann hinsichtlich Design und Materialauswahl wesentlich besser an den jeweiligen Anwendungsfall optimiert werden.

Das Grundbauelement (der Grundkörper) enthält den optischen Sender oder Empfänger. Bei optischen Sendern ist es vorteilhaft, die Halbleiterbauelemente in einem Reflektor zu montieren. Dieser Reflektor kann durch Umhüllung mit einem reflektierenden, gegebenfalls hochreflektierenden, Kunststoff ausgebildet werden.

SMD-Bauelemente sind aus EP-A-0 218 832, aus DE-A-32 31 277 und aus der PCT-Patentanmeldung WO-A-85/01634 bekannt.

Die Erfindung wird im folgenden anhand der Zeichnung näher erläutert.

FIG 1 erläutert die Herstellung von Grundkörpern.

FIG 2 zeigt schematisch mögliche Grundkörper.

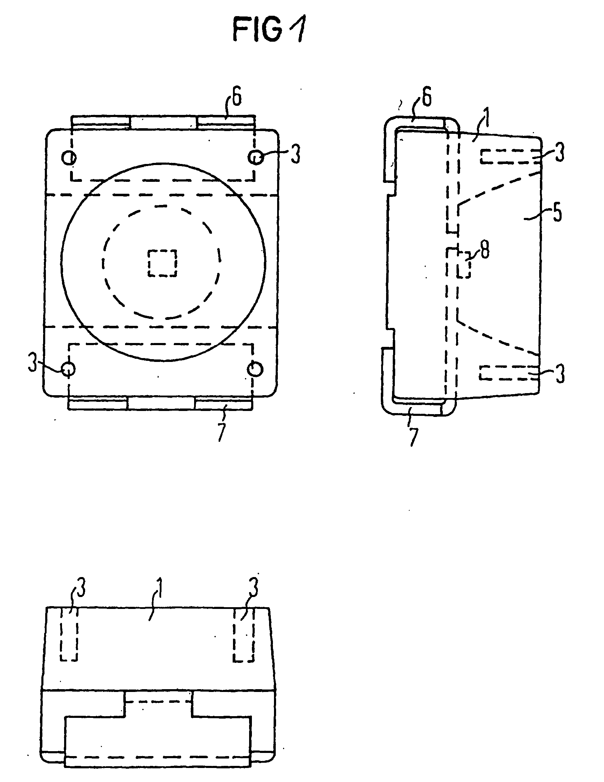

FIG 1 erläutert die Herstellung von Grundkörpern 1. Die elektrischen Anschlüsse 6, 7 werden während des Aufbringens des Halbleiterkörpers 8 und der Bond-Draht-Verbindung zwischen dem Halbleiterkörper 8 und dem elektrischen Anschluß 6 in sogenannter Leiterrahmen-Technik (lead-frame-Technik) zusammengehalten. Zuerst wird der Leiterrahmen (lead-frame) mit Kunsstoff, beispielsweise mit Thermoplast, umspritzt und erst dann wird im Inneren der Vertiefung 5 ein Halbleiterkörper 8 angeordnet . Schließlich kann die Vertiefung 5 mit Gießharz ausgegossen werden. In der Umhüllung des Grundkörpers 1 können Justierhilfen wie z.B. Bohrungen 3 vorgesehen sein. Die elektrischen Anschlüsse 6, 7 sind in dem Bereich, in dem sie aus der Umhüllung des Grundkörpers 1 herausragen, so gebogen, daß sie wie bei FIG 1 nach unten zur Mitte der Umhüllung des Grundkörpers hin gebogen sind.

Für den Grundkörper 1 werden bei der Erfindung nur wenige Grundformen benötigt. Außerdem ist Kunststoffmaterial, das die bei der Oberflächenmontage auftretenden hohen Temperaturen und sonstigen Belastungen aushält, nur in geringem Umfang erforderlich. Für die Umhüllung des Grundkörpers 1 können alle SMD-fähigen Materialien verwendet werden. Für die Umhüllung des Grundkörpers 1 kann beispielsweise LCP (Liquid Crystal Polymer)-Material verwendet werden. Obwohl nur wenige Grundformen 1 benötigt werden, ermöglicht die Erfindung eine große Gestaltungsfreiheit bei der Ausgestaltung von Opto-Bauelementen.

Wird ein Thermoplast für die Umhüllung des Grundkörpers 1 verwendet, so hält dieser Kunststoff die üblichen Löt-Temperaturen zwischen 200 und 280°C aus.

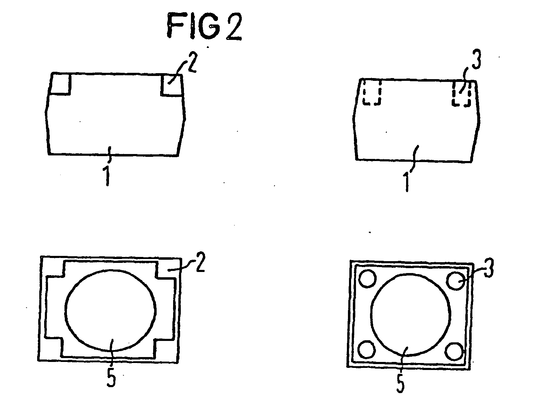

FIG 2 zeigt schematisch mögliche Ausführungsformen für Grundkörper 1. Die Grundkörper 1 enthalten eine Vertiefung 5, in der ein optischer Sender oder ein optischer Empfänger angeordnet ist. Diese Vertiefung kann vorteilhafterweise bei optischen Sendern als Reflektor ausgebildet sein. Die Vertiefung 5 ist vorteilhafterweise mit Gießharz vergossen. Diejenige Oberfläche des Grundkörpers 1, die von demjenigen Substrat, auf das der Grundkörper 1 montiert wird, abgewandt ist, ist im wesentlichen plan.

## Patentansprüche

1. Verfahren zum Herstellen eines oberflächenmontierbaren Opto-Bauelements, bei dem
- an einem Leiterrahmen (Leadframe) mittels Umspritzen mit Kunststoff ein Grundkörper (1) mit einer Vorderseite und einer Rückseite und mit einer von der Vorderseite ausgehenden Vertiefung (5) ausgebildet wird und nachfolgend ein optischer Sender oder Empfänger (8) in der Vertiefung (5) angeordnet und mittels Bond-Draht-Verbindung mit einem elektrischen Anschluß (6) des Leiterrahmens verbunden wird,
- der Leiterrahmen zwei elektrische Anschlüsse (6,7) aufweist, die, gesehen von der Grundkörpermitte, schmale Bereiche und diesen nachgeordnete breitere Bereiche aufweisen, die jeweils zusammenhängen,
- der Grundkörper (1) derart ausgebildet wird, dass die elektrischen Anschlüsse (6,7) auf einander gegenüberliegenden Seitenflächen des Grundkörpers (1) im Verlauf der schmalen Bereiche aus dem Grundkörper (1) herausragen, und
- die elektrischen Anschlüsse (6,7) in den schmalen Bereichen zur Rückseite des Grundkörpers (1) hin gebogen werden und im weiteren Verlauf in den breiteren Bereichen auf Höhe der Rückseite des Grundkörpers (1) zu dessen Mitte hin gebogen werden und an der Rückseite des Grundkörpers vollständig an diesen angelegt werden.

2. Verfahren nach Anspruch 1, bei dem nach dem Montieren des Senders oder Empfängers (8) die Vertiefung mit Gießharz vergossen wird.

3. Verfahren nach Anspruch 1 oder 2, bei dem die Vertiefung als Reflektor ausgebildet wird und in dieser ein optischer Sender angeordnet wird.

4. Verfahren nach einem der Ansprüche 1 bis 3, bei dem die Vorderseite des Grundkörpers (1) im Wesentlichen plan ausgebildet wird.

5. Verfahren nach einem der Ansprüche 1 bis 4, bei dem der Grundkörper (1) aus einem reflektierenden Kunststoff hergestellt wird.

6. Verfahren einem der Ansprüche 1 bis 5, bei dem der Grundkörper (1) aus einem Thermoplast hergestellt ist.

7. Oberflächenmontierbares Opto-Bauelements, bei dem
- an einem Leiterrahmen (Leadframe) mittels Umspritzen mit Kunststoff ein Grundkörper (1) mit einer Vorderseite und einer Rückseite und mit einer von der Vorderseite ausgehenden Vertiefung (5) ausgebildet ist,
- in der Vertiefung (5) ein optischer Sender oder Empfänger (8) angeordnet ist, der mittels Bond-Draht-Verbindung mit einem elektrischen Anschluß (6) des Leiterrahmens verbunden ist,
- der Leiterrahmen zwei elektrische Anschlüsse (6,7) aufweist, die, gesehen von der Grundkörpermitte, schmale Bereiche und diesen nachgeordnete breitere Bereiche aufweisen, die jeweils zusammenhängen,
- der Grundkörper (1) derart ausgebildet ist, dass die elektrischen Anschlüsse (6,7) auf einander gegenüberliegenden Seitenflächen des Grundkörpers (1) im Verlauf der schmalen Bereiche aus dem Grundkörper (1) herausragen, und
- die elektrischen Anschlüsse (6,7) in den schmalen Bereichen zur Rückseite des Grundkörpers (1) hin gebogen sind und im weiteren Verlauf in den breiteren Bereichen auf Höhe der Rückseite des Grundkörpers (1) zu dessen Mitte hin gebogen sind und an der Rückseite des Grundkörpers vollständig an diesem anliegen.

8. Opto-Bauelement nach Anspruch 7, bei dem die Vertiefung mit Gießharz vergossen ist.

9. Opto-Bauelement nach Anspruch 7 oder 8, bei dem die Vertiefung als Reflektor ausgebildet ist und in dieser ein optischer Sender angeordnet ist.

10. Opto-Bauelement nach einem der Ansprüche 7 bis 9, bei dem die Vorderseite des Grundkörpers (1) im Wesentlichen plan ausgebildet ist.

11. Opto-Bauelement nach einem der Ansprüche 7 bis 10, bei dem der Grundkörper (1) aus einem reflektierenden Kunststoff hergestellt ist.

12. Opto-Bauelement nach einem der Ansprüche 7 bis 11, bei dem der Grundkörper (1) aus einem Thermoplast hergestellt ist.

## Claims

1. Method of producing a surface-mountable optical component, in which
- on a leadframe, by means of encapsulation with plastic, a basic element (1) having a front side and a rear side and having a depression (5) originating from the front side is formed and then an optical transmitter or receiver (8) is arranged in the depression (5) and, by means of bonding-wire connection, is connected to an electrical connection (6) of the leadframe,
- the leadframe has two electrical connections (6, 7) which, as viewed from the centre of the basic element, have narrow regions and broader regions arranged after these, which are joined together in each case,
- the basic element (1) is designed in such a way that the electrical connections (6, 7) on mutually opposite side surfaces of the basic element (1) project out of the basic element (1) in the course of the narrow regions, and
- the electrical connections (6, 7) in the narrow regions are bent over towards the rear of the basic element (1) and, in the further course in the broader regions, are bent over towards the centre of the basic element (1) at the level of the rear of the latter and, on the rear of the basic element, are placed completely against the latter.

2. Method according to Claim 1, in which the depression is cast with casting resin following the mounting of the transmitter or receiver (8).

3. Method according to Claim 1 or 2, in which the depression is formed as a reflector and an optical transmitter is arranged therein.

4. Method according to one of Claims 1 to 3, in which the front side of the basic element (1) is substantially flat.

5. Method according to one of Claims 1 to 4, in which the basic element (1) is produced from a reflective plastic.

6. Method according to one of Claims 1 to 5, in which the basic element (1) is produced from a thermoplastic.

7. Surface-mountable optical component, in which
- on a leadframe, by means of encapsulation with plastic, a basic element (1) having a front side and a rear side and a depression (5) originating from the front side is formed,
- arranged in the depression (5) is an optical transmitter or receiver (8), which is connected to an electrical connection (6) of the leadframe by means of a bonding-wire connection,
- the leadframe has two electrical connections (6, 7) which, as viewed from the centre of the basic element, have narrow regions and broader regions arranged after these, which are joined together in each case,
- the basic element (1) is designed in such a way that the electrical connections (6, 7) on mutually opposite side surfaces of the basic element (1) project out of the basic element (1) in the course of the narrow regions, and
- the electrical connections (6, 7) in the narrow regions are bent over towards the rear of the basic element (1) and, in the further course in the broader regions, are bent over towards the centre of the basic element (1) at the level of the rear of the latter and, on the rear of the basic element, rest completely against the latter.

8. Optical component according to Claim 7, in which the depression is cast with casting resin.

9. Optical component according to Claim 7 or 8, in which the depression is formed as a reflector and an optical transmitter is arranged therein.

10. Optical component according to one of Claims 7 to 9, in which the front side of the basic element (1) is substantially flat.

11. Optical component according to one of Claims 7 to 10, in which the basic element (1) is produced from a reflective plastic.

12. Optical component according to one of Claims 7 to 11, in which the basic element (1) is produced from a thermoplastic.

## Revendications

1. Procédé de production d'un composant optique qui peut être monté en surface, dans lequel
- on constitue sur une grille de connexion (leadframe) au moyen d'un moulage de matière plastique par injection un corps de base (1) ayant une face avant et une face arrière et une cavité (5) partant de la face avant et, ensuite, on met un émetteur ou un récepteur (8) optique dans la cavité (5) et on le relie au moyen d'une liaison par fil de liaison à une sortie (6) électrique de la grille de connexion,
- la grille de connexion a deux sorties (6, 7) électriques qui, vues depuis le milieu du corps de base, ont des parties étroites et des parties plus larges disposées après celles-ci, qui sont respectivement d'un seul tenant,
- le corps de base (1) est constitué de façon à ce que les sorties (6, 7) électriques fassent saillie du corps de base (1) sur des surfaces latérales opposées l'une à l'autre du corps de base (1) dans le tracé des parties étroites, et
- les sorties (6, 7) électriques dans les parties étroites sont coudées vers la face arrière du corps de base (1), et sont coudées plus loin dans les parties plus larges au niveau de la face arrière du corps de base (1) vers son milieu, et sur la face arrière du corps de base sont appliquées complètement contre celui-ci.

2. Procédé suivant la revendication 1, dans lequel, après le montage de l'émetteur ou du récepteur (8), on coule de la résine de coulée dans la cavité.

3. Procédé suivant la revendication 1 ou 2, dans lequel on constitue la cavité en réflecteur et on y dispose un émetteur optique.

4. Procédé suivant l'une des revendications 1 à 3, dans lequel on constitue la face avant du corps de base (1) d'une manière sensiblement plane.

5. Procédé suivant l'une des revendications 1 à 4, dans lequel on produit le corps de base (1) en une matière plastique réfléchissante.

6. Procédé suivant l'une des revendications 1 à 5, dans lequel on produit le corps de base (1) en une matière thermoplastique.

7. Composant optique qui peut être monté en surface, dans lequel
- il est constitué sur une grille de connexion (leadframe) au moyen d'un moulage de matière plastique par injection un corps de base (1) ayant une face avant et une face arrière et ayant une cavité (5) partant de la face avant,
- il est disposé dans la cavité (5) un émetteur ou récepteur (8) optique qui est relié au moyen d'une liaison par fil de liaison à une sortie (6) électrique de la grille de connexion,
- la grille de connexion a deux sorties (6, 7) électriques qui, vues depuis le milieu du corps de base, ont des parties étroites et des parties plus larges disposées après celles-ci, qui sont respectivement d'un seul tenant,
- le corps de base (1) est constitué de façon à ce que les sorties (6, 7) électriques fassent saillie du corps de base (1) sur des surfaces latérales opposées l'une à l'autre du corps de base (1) dans le tracé des parties étroites, et
- les sorties (6, 7) électriques dans les parties étroites sont coudées vers la face arrière du corps de base (1), et sont coudées plus loin dans les parties plus larges au niveau de la face arrière du corps de base (1) vers son milieu, et sur la face arrière du corps de base sont appliquées complètement contre celui-ci.

8. Composant optique suivant la revendication 7, dans lequel la cavité est remplie de résine de coulée.

9. Composant optique suivant la revendication 7 ou 8, dans lequel on constitue la cavité en réflecteur et on y dispose un émetteur optique.

10. Composant optique suivant l'une des revendications 7 à 9, dans lequel on constitue la face avant du corps de base (1) d'une manière sensiblement plane.

11. Composant optique suivant l'une des revendications 7 à 10, dans lequel on produit le corps de base (1) en une matière plastique réfléchissante.

12. Composant optique suivant l'une des revendications 7 à 11, dans lequel on produit le corps de base (1) en une matière thermoplastique.
